# EUROPÄISCHE PATENTSCHRIFT

(11) **EP 0 693 823 B1**
(45) Veröffentlichungstag und Bekanntmachung des Hinweises auf die Patenterteilung: **18.04.2001**
(21) Anmeldenummer: 95110931.3
(22) Anmeldetag: 12.07.1995
(51) Int. Cl.: H03F 1/30

(54) **Schaltungsanordnung, insbesondere für digitale Modulationseinrichtungen**
Circuit especially for digital modulation apparatuses
Circuit spécialement pour des appareils de modulation digitale

(30) Priorität: 18.07.1994 DE 4425338
(43) Veröffentlichungstag der Anmeldung: 24.01.1996
(73) Patentinhaber: Infineon Technologies AG, 81669 München (DE)
(72) Erfinder: Fenk, Josef, Dipl.-Ing., D-85386 Eching (DE); Sehrig, Peter, Ing. grad., D-82343 Pöcking (DE)
(74) Vertreter: Zedlitz, Peter, Dipl.-Inf.

(56) Entgegenhaltungen:
- EP-A- 0 032 551
- FR-A- 2 552 551
- GB-A- 2 093 652
- US-A- 5 270 883
- NEUES AUS DER TECHNIK, Nr. 6, 1.Dezember 1972 WURZBURG DE, 'TEMPERATURDRIFTSTABILISIERUNG FÜR EINEN PERIODISCHEN VERVIELFACHER'

## Beschreibung

Die Erfindung betrifft eine Schaltungsanordnung, insbesondere für digitale Modulationseinrichtungen, mit einer Differenzverstärkerschaltung, die über eine Ausgangsstufe mit einer Filterschaltung verbunden ist.

Aus dem Stand der Technik US 5,270,883 ist eine Schaltung für magnetische Schreib-/Leseköpfe bekannt, der die Aufgabe zugrunde liegt, nur geringe Offsetschwankungen am Ausgang zu erzeugen, wenn zwischen den Schreib-/Leseköpfen umgeschaltet wird. Die Aufgabe wird dadurch gelöst, daß mittels einer negativen Rückkopplung der Offset reduziert wird, der durch den Verstärker des Schreib-/Lesekopfs erzeugt wird.

Aus der Veröffentlichung R. Mäusl: Digitale Modulationsverfahren, zweite Auflage, Hüthig-Verlag, 1988, Seite 189 ist eine Differenzverstärkerschaltung mit einer nachgeschalteten Ausgangsstufe bekannt. Die Schaltungsanordnung wird bei der digitalen Modulation oder Demodulation eines Sinusträgers nach dem Prinzip der Phasenumtastung als Mischerschaltung eingesetzt und als Gilbertzelle bezeichnet.

Das Ausgangssignal dieser Schaltung muß weiter verarbeitet werden, was mit einer Filterschaltung geschieht. Die Signalkopplung zwischen den einzelnen Schaltungsstufen erfolgt üblicherweise nur für das AC-Signal.

Oft ist eine DC-Signalkopplung zwischen den einzelnen Schaltungsstufen erwünscht. Beispielsweise zeigt FIG 6 den Eingangsteil eines drahtlosen Kommunikationsempfängers. Das an der Antenne A empfangene Signal wird über ein Bandpaßfilter F1 einem niedrigrauschenden Verstärker V1 und nach einem weiteren Bandpaßfilter F2 einem ersten Mischer M1 zugeführt. Vom Ausgang des Mischers M1 gelangt das Signal über ein Filter F3 (Kanalfilter) und einen Verstärkungsregler R1 zu einem zweiten Mischer 1, dessen Ausgangssignal über eine Ausgangsstufe 2 einem Basisbandfilter 3 sowie einem nachgeschalteten Analog/Digital-Wandler 4 zugeführt wird. Das Eingangssignal wird bei einer Bandselektion in dem niedrigrauschenden Verstärker V1 verstärkt und anschließend in eine Zwischenfrequenz umgesetzt. Nach der Kanalselektion mit Hilfe des Filters F3 wird das Signal je nach Stärke verstärkt oder abgeschwächt (R1) und in einem Demodulator aus den Elementen, 1 und 2 ins Basisband umgesetzt.

Im Signalverlauf können Störsignale auftreten, die an der Antenne um 75 dB über dem Nutzsignal liegen (beispielsweise GSM). Das Kanalfilter kann die Störsignale nur um ca. 45 dB absenken. Um die Störsignale weiter zu dämpfen, wird dem Demodulator das Basisbandfilter 3 nachgeschaltet. Dieses Filter senkt die Störsignale um weitere etwa 30 dB ab, so daß am Ausgang des Basisbandfilters das Nutzsignal und das Störsignal etwa gleiche Stärke haben und das Störsignal nach der Umsetzung in ein Digitalsignal mit Hilfe des A/D-Wandlers 4 durch ein Digitalfilter in der Digitaleinheit entgültig auf einen nicht mehr störenden Pegel abgesenkt werden kann. Das Basisbandfilter 3 ist in der Regel als Aktivfilter ausgebildet. Dieses Filter verstärkt das Nutzsignal um etwa 30 dB. Typischerweise werden alle Schaltungselemente dieses Filters differentiell ausgeführt, um eine hohe Störfestigkeit zu erzielen. Das bedeutet, daß die an der Ausgangsstufe 2 des Demodulators auftretenden differentiellen DC-Offsetspannungen, die beispielsweise durch Fertigungstoleranzen bedingt sind, im Basisband-Filter 3 um ebenfalls 30 dB verstärkt werden. Am Ausgang des Basisband-Filters können dann differentielle Offsetspannungen in der Nähe von 1 V auftreten. Eine derart hohe Offsetspannung führt bei einer DC-Kopplung zu den nachfolgenden Schaltungselementen, im Beispiel zu dem A/D-Wandler 4, zu einer massiven Einengung des Aussteuerbereichs.

Denkbar ist eine Lösung des genannten Problems durch eine AC-Kopplung zwischen dem Ausgang des Basisbandfilters und der nachfolgenden Schaltungseinheit. Eine derartige AC-Kopplung führt aber zu einem erheblichen externen Schaltungsaufwand, insbesondere im Burst-Betrieb, wie er bei netzunabhänigen Einrichtungen vorgesehen ist. Wenn beispielsweise die Grenzfrequenz des Basisbandfilters niedrig ist (im Beispiel GSM etwa 80 kHz), müssen zur Kopplung große Koppelkondensatoren verwendet werden, durch die wiederum beim Einschalten bzw. beim Burst-Betrieb große Zeitkonstanten entstehen. Zum Ausgleich der auftretenden Potentialunterschiede in der differentiellen Anordnung sind Operationsverstärker, z. B. als Spannungsfolger geschaltet, sowie Quertransistoren erforderlich. Eine integrierte Ausführung des Demodulators und des Basisbandfilters ist deshalb, wenn überhaupt möglich, sehr teuer.

Der Erfindung liegt die Aufgabe zugrunde, die eingangs genannte Schaltungsanordnung zu verbessern.

Diese Aufgabe löst die Erfindung mit den Merkmalen des Patentanspruchs 1.

Die Erfindung hat den Vorteil, daß vom Ausgang des Demodulators bis zur Schaltungseinheit, die auf das Basisbandfilter folgt, eine symmetrische DC-Kopplung möglich ist und somit eine deutlich verringerte Peripherieschaltung vorgesehen werden kann. Das DC-Offsetsignal am Ausgang der Filterschaltung 3 wird durch die erfindungsgemäßen Merkmale auf ein Minimum reduziert. Für den Regelkreis ist lediglich ein Ladekondensator notwendig, der so ausgenutzt wird, daß das Offsetsignal der symmetrischen Nutzsignalpfade gespeichert und im Zuge der Regelung kompensiert wird.

Ausgestaltungen der Erfindung sind in Unteransprüchen gekennzeichnet.

Die Erfindung wird nachfolgend anhand von in den Figuren der Zeichnung dargestellten Ausführungsbeispielen näher beschrieben.

Es zeigen:
FIG 1 ein Prinzipschaltbild der erfindungsgemäßen Schaltungsanordnung,
FIG 2 ein Detail-Schaltbild der Elemente der Rückkoppelschleife der Regelschaltung,
FIG 3 eine detaillierte Schaltung einer Signalversorgung für die Regelschaltung,
FIG 4 eine detaillierte Schaltung der Differenzverstärkerschaltung und der Ausgangsstufe,
FIG 5 eine detaillierte Filterschaltung und
FIG 6 das bereits erwähnte Beispiels einer bekannten Signalverarbeitung.

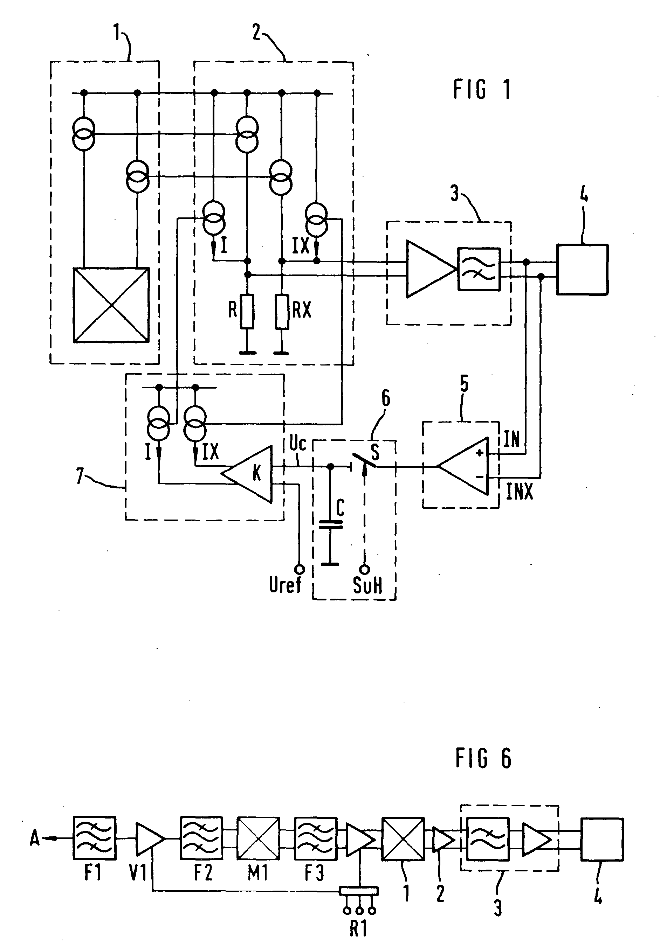

Gemäß FIG 1 enthält der Demodulator die Differenzverstärkerschaltung 1 und die nachgeschaltete Ausgangsstufe 2. Das Prinzipschaltbild der FIG 1 zeigt die Differenzverstärkerschaltung als Mischer- bzw. Multiplikatorschaltung mit differentiellem Ausgang dargestellt. Der differentielle Ausgang speist über zwei Stromquellen das Ausgangssignal in zwei Stromquellen der Ausgangsstufe 2 ein, die zwei Lastwiderstände R und RX treiben. An den Verbindungspunkten der Lastwiderstände mit den zugeordneten Stromquellen werden die Eingangssignale für die Filterschaltung 3 abgegriffen. Die Ausgangsspannung der Filterschaltung 3 bzw. des in der Filterschaltung enthaltenen Operationsverstärkers wird differentiell abgegriffen. Die differentielle Ausgangsspannung steuert eine erste Teilschaltung 5, die als Operationsverstärker ausgebildet ist. Der Ausgang der ersten Teilschaltung wiederum steuert eine Abtast- und Halteschaltung 6, die im Prinzip aus einem Schalter S und einer Kapazität C besteht.

Der Schalter S wird von einer Klemme SuH gesteuert und verbindet den Ausgang der ersten Teilschaltung im geschlossenen Zustand mit der Kapazität C. Da der Offsetabgleich vor der Nutzsignalverarbeitung erfolgen muß, beispielsweise vor dem jeweiligen Burst-Signal, wird der Schalter S zu diesen Zeitpunkten geschlossen. Das Steuersignal an der Klemme SuH kann beispielsweise vom vorangegangenen Burst-Signal abgeleitet werden.

Der Verbindungspunkt des Schalters S mit der Kapazität C ist auf einen Eingang einer zweiten Teilschaltung 7 geführt, deren anderer Eingang auf einem Referenzpotential Uref liegt. Die zweite Teilschaltung 7 kann beispielsweise einen Komparator mit einem differentiell ausgeführten Stromquellenausgang enthalten. Die Spannung Uc der Kapazität als Ausgang der Abtast- und Halteschaltung 6 sowie die Referenzspannung Uref werden dem Komparator als Eingangsspannungen zugeführt. Abhängig vom Ergebnis des im Komparator durchgeführten Vergleichs werden die ausgangsseitigen differentiellen Stromquellen aktiviert und erzeugen einen Strom I bzw. IX. Diese Ausgangsströme werden differentiell beispielsweise mit Hilfe einer Stromspiegelschaltung in die Ausgangsstufe 2 übertragen. Parallel zu den Stromquellen für das von der Differenzverstärkerschaltung 1 kommende Signal werden die von der zweiten Teilschaltung 7 stammenden Ströme zu den Lastelementen R und RX geführt. Das auf diese Weise durch die Ströme I bzw. IX in die Ausgangsstufe 2 eingespeiste Offset-Kompensationssignal kompensiert das von der Differenzverstärkerschaltung 1 stammende Offsetsignal derart, daß das Offsetsignal am Eingang der Filterschaltung 3 minimal wird. Ein der Filterschaltung 3 nachgeschaltetes Schaltungselement 4, beispielsweise ein A/D-Wandler, kann deshalb DC-gekoppelt mit der Filterschaltung 3 verbunden werden.

Die in FIG 1 dargestellte Schaltungsanordnung arbeitet folgendermaßen. An geeigneter Stelle, beispielsweise am Ausgang der Filterschaltung, wird das verstärkte Nutzsignal differentiell abgegriffen und über die erste Teilschaltung der Abtast- und Halteschaltung zugeführt. Mit Hilfe der ersten Teilschaltung 5 wird abhängig von der Polarität der differentiellen Ausgangsspannung der Filterschaltung, d.h. abhängig von der Polarität der Offsetspannung die Kapazität C der Abtastund Halteschaltung 6 geladen oder entladen.

Wenn die Offsetspannung 0 ist, entspricht die an der Kapazität C anliegende Spannung Uc der Referenzspannung Uref. Die der Abtast- und Halteschaltung nachgeschaltete zweite Teilschaltung 7 liefert an ihren differentiellen Ausgängen in diesem Fall zwei gleich große Kompensationsströme I und IX. Diese parallel zu den von der Differenzverstärkerschaltung 1 gesteuerten Stromquellen eingespeisten Ströme der Regelschaltung erzeugen an den Lastwiderständen R und RX gleiche Signale und wirken sich somit differentiell nicht auf den Eingang der Filterschaltung aus.

Wenn am Ausgang der Filterschaltung 3 eine Offsetspannung auftritt, also eine Differenz der Ausgangsspannungen größer oder kleiner 0 auftritt, verursacht die erste Teilschaltung 5 ein Aufladen oder Entladen der Kapazität C. Dadurch ist die Eingangsspannung Uc der zweiten Teilschaltung 7 größer oder gleich der Referenzspannung Uref am zweiten Eingang. Entsprechend werden die Ausgangsströme I und IX der zweiten Teilschaltung ungleich und demzufolge fällt über den Lastwiderständen R und RX der Ausgangsstufe 2 eine Offset-Kompensationsspannung ab, die der Offsetspannung am Ausgang der Filterschaltung 3 entgegengesetzt gerichtet ist und diese Offsetspannung somit kompensiert. Mit Hilfe des Regelkreises erfolgt die Regelung derart, daß die Offsetspannung am Ausgang der Filterschaltung null oder minimal wird. Die Ausgangsspannung Uc der Abtast- und Halteschaltung 6 als einer Eingangsspannung der zweiten Teilschaltung 7, entspricht dann der Referenzspannung Uref. Nach dem derart erfolgten Offsetabgleich wird der Schalter S der Abtast- und Halteschaltung 6 geöffnet, was durch Stromlosschalten eines Operationsverstärkers der ersten Teilschaltung 5 realisiert werden kann. Die Kapazität C der Abtast- und Halteschaltung 6 sorgt dafür, daß die Spannung Uc bei geöffnetem Schalter S im wesentlichen konstant gehalten wird und somit die Offset-Kompensation bestehen bleibt.

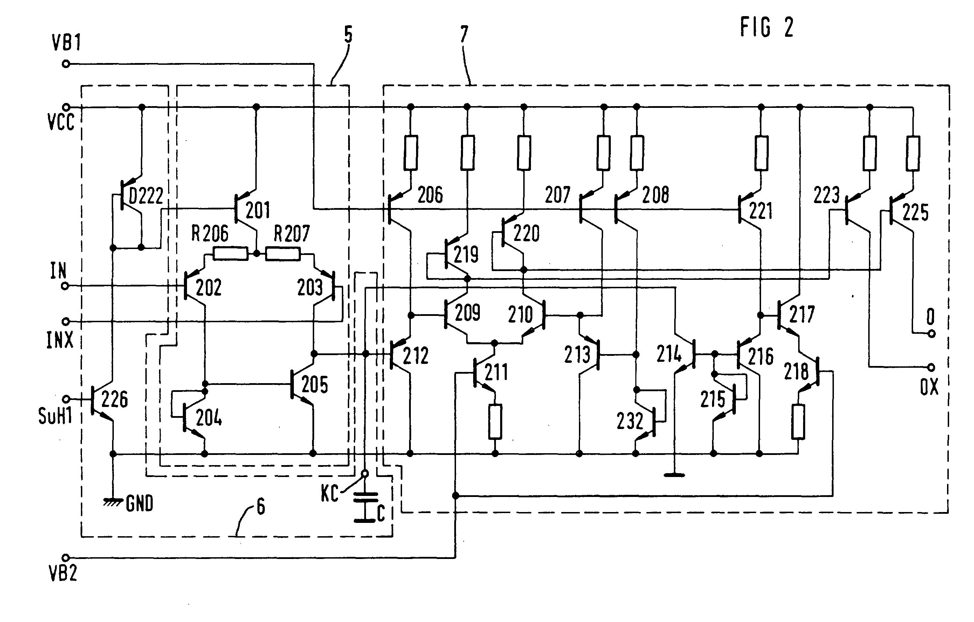

FIG 2 zeigt die Elemente 5, 6 und 7 des Regelkreises. Die erste Teilschaltung 5 enthält im wesentlichen einen Differenzverstärker aus den Transistoren 202 und 203, die emitterseitig über die Widerstände R206 und R207 verbunden sind. Am Verbindungspunkt der Widerstände ist eine Stromquelle mit dem Transistor 201 angeschlossen. Ausgangsseitig arbeitet die Differenzverstärkerstufe des Operationsverstärkers auf den als Diode geschalteten Transistor 204 und den Transistor 205. Der Eingang der ersten Teilschaltung 5, d.h. die Basisanschlüsse der Transistoren 202 bzw. 203 werden über Klemmen IN und INX vom Ausgang der Filterschaltung 3 gespeist.

Die Abtast- und Halteschaltung 6 enthält als Schalter S die Serienschaltung der Diode D 222 und des Transistors 226. Der Verbindungspunkt der beiden Elemente steuert den Basisanschluß des als Stromquelle für den Operationsverstärker dienenden Transistor 201 und wird von einer Klemme SuHl gesteuert. Schließen des Schalters bedeutet Durchschalten des Transistors 226, so daß der Spannungsabfall am Emitter-Basis-Übergang des Transistors 201 ausreichend hoch wird, um diesen als Stromquelle zu aktivieren. Bei nicht durchgeschaltetem Transistor 226 wird der Operationsverstärker der ersten Teilschaltung 5 stromlos geschaltet, da die Diode D222 parallel zur Emitter-Basis-Diode des Transistors 201 liegt und dieser somit sperrt.

Das zweite Element der Abtast- und Halteschaltung ist der über eine Klemme KC extern angeschaltete Kondensator C. Die Klemme KC ist mit dem Ausgang des Transistors 203 bzw. dem Lasttransistor 205 verbunden.

Die zweite Teilschaltung 7 enthält im wesentlichen den Differenzverstärker aus den Transistoren 209 und 210. Der Transistor 209 wird eingangsseitig über den vorgeschalteten Transistor 212 mit der Ausgangsklemme KC der Abtast- und Halteschaltung verbunden und gesteuert. Am zweiten Eingang des Differenzverstärkers liegt die Spannung Uref, die über den Transistor 213 die Basis des Transistors 210 steuert. Die Referenzspannung wird an einer Diode 232 abgegriffen, die über einen Transistor 208 mit dem Versorgungspotential verbunden ist. Die Basis des Transistors 208 ist ebenso wie die Basen zweier Transistoren 206 und 207 mit einem ersten Vorspannungspotential VB1 verbunden .Die Transistoren 206 und 207 dienen zur Arbeitspunkteinstellung des Differenzverstärkers und sind ausgangsseitig mit den Basen der Transistoren 209 und 210 verbunden. Die Differenzverstärkerstufe wird emitterseitig von der Stromquelle 211 gespeist, die an einer zweiten Vorspannung VB2 liegt. Ausgangsseitig arbeiten die Transistoren 209 und 210 auf zwei als Dioden geschaltete Lastelemente 219 und 220, an denen Eingangsspannungen für die Ausgangstransistoren 223 und 225 abgegriffen werden. An den Kollektoren der letzteren Transistoren liegen die Ausgangsklemmen O und OX, die mit der Ausgangsstufe 2 verbunden sind.

Um die Entladung der Kapazität C der Abtast- und Halteschaltung 6 aufgrund des Basisstroms des Transistors 212 zu verhindern, ist eine Basisstromkompensation vorgesehen, die die Transistoren 214 bis 218 und 221 enthält. Im Prinzip ist durch diese Schaltung die halbe Differenzverstärkerstufe der zweiten Teilschaltung 7 nachgebildet. Die Stromquelle 218 wird von der Klemme VB2 versorgt und speist einen Transistor 217, dessen Arbeitspunkt über den Transistor 221 in gleicher Weise wie bei den Transistoren 209 bzw. 210 eingestellt wird. Eingangsseitig ist dem Transistor 217 ein Transistor 216 vorgeschaltet, dessen Basis über einen als Diode geschalteten Transistor 215 mit Bezugspotential verbunden ist, so daß Element 215 als Klemmschaltung wirkt. Auf gleichem Potential wie die Basis des Transistors 216 liegt die Basis eines Transistors 214, der ausgangsseitig mit der Basis des Transistors 212 zur Einkopplung des Basiskompensationsstroms verbunden ist.

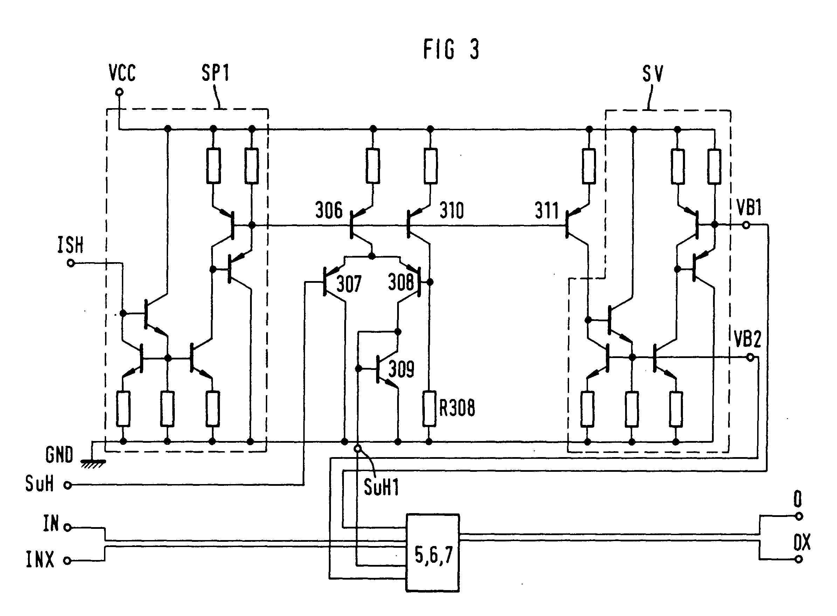

FIG 3 zeigt im Prinzip die Erzeugung der Vorspannungen VB1 und VB2 sowie des Steuersignals an der Klemme SuH1. Die in FIG 2 dargestellte Schaltungsanordnung ist als Block in FIG 3 dargestellt. An der Klemme ISH wird ein Strom in eine Stromspiegelanordnung SP1 eingespeist, der ausgangsseitig Stromquellentransistoren 306, 310 und 311 speist. Der Stromquellentransistor 306 versorgt einen Differenzverstärker aus den Transistoren 307 und 308. Transistor 307 wird von einer Klemme SuH gesteuert, während Transistor 308 von einer Festspannung gespeist wird, die sich aus der Spannung ergibt, die über dem von dem Transistor 310 gespeisten Widerstand R 308 abfällt. Der Ausgang des Transistors 308 arbeitet auf das Lastelement des als Diode geschalteten Transistor 309, an dem der Anschluß SuHl abgegriffen wird. Der weitere Stromquellentransistor 311 arbeitet ausgangsseitig auf eine Schaltungsanordnung SV mit zwei Ausgängen VB1 und VB2 unterschiedlichen Potentials.

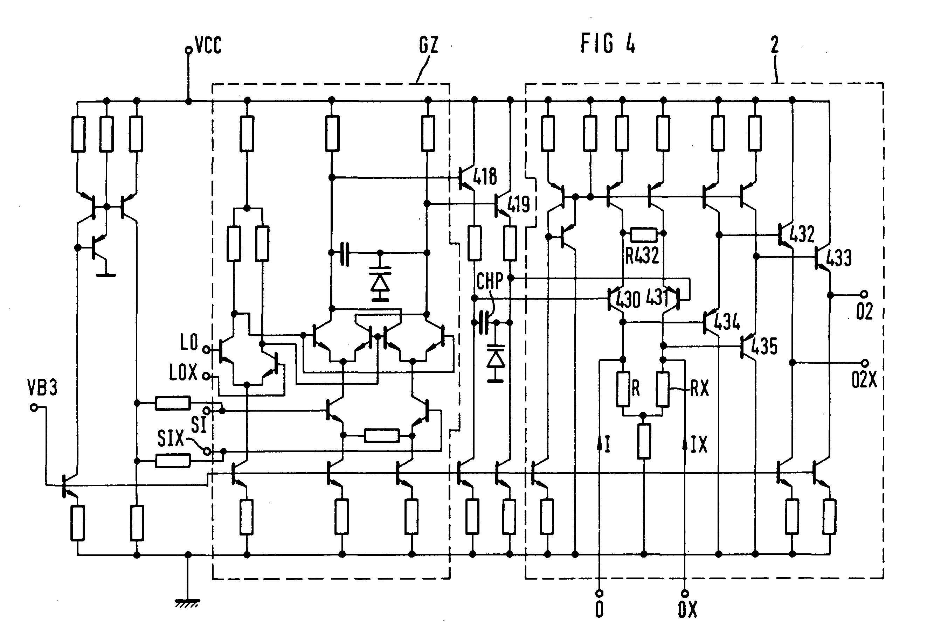

FIG 4 zeigt Detailschaltungen der Differenzverstärkerschaltung 1 und der Ausgangsstufe 2. Die Differenzverstärkerschaltung 1 enthält im wesentlichen eine Gilbertzelle GZ, in der die differentiellen Signale eines lokalen Oszillators an den Klemmen LO und LOX mit differentiellen Nutzsignalen an den Klemmen SI und SIX gemixt werden. Die Ausgänge der Gilbertzelle GZ arbeiten auf zwei Emitterfolger 418 und 419, deren differentielle Ausgänge auf die Eingangstransistoren 430 und 431 der Ausgangsstufe 2 geführt werden. Vorgesehen ist eine Kapazität CHP zwischen den Ausgängen der Transistoren 418 und 419, die eine Hochpaßfilterung bewirkt.

Die Eingangstransistoren 430 und 431 der Ausgangsstufe 2 sind emitterseitig über einen Widerstand R432 gekoppelt und werden von einer nicht näher dargestellten Stromquelle versorgt. Ausgangsseitig arbeiten die Transistoren 430 und 431 auf Lastwiderstände R und RX. Die Verbindungspunkte der Lastwiderstände R und RX mit den Transistoren 430 und 431 sind ebenfalls mit den Klemmen O und OX der Regelschaltung verbunden, so daß ein Offset-Kompensationssignal, im Ausführungsbeispiel die Kompensationsströme I und IX in die Ausgangsstufe eingespeist werden kann. Der Spannungsabfall an den Lastelementen R und RX wird ausgangsseitig über Emitterfolgertransistoren 432 bis 433 in den differentiellen Ausgang 02 bzw. O2X der Ausgangsstufe eingespeist.

Die Stromversorgung der Schaltungsanordnung gemäß FIG 4 erfolgt über eine Klemme VB3 mit Hilfe nicht näher dargestellter Stromspiegel und Stromquellentransistoren. Zu erwähnen ist, daß die Stromquellentransistoren ebenso wie Stromquellentransistoren, wie sie in den FIG 2 und 3 gezeigt sind, emitterseitig einen Widerstand aufweisen können.

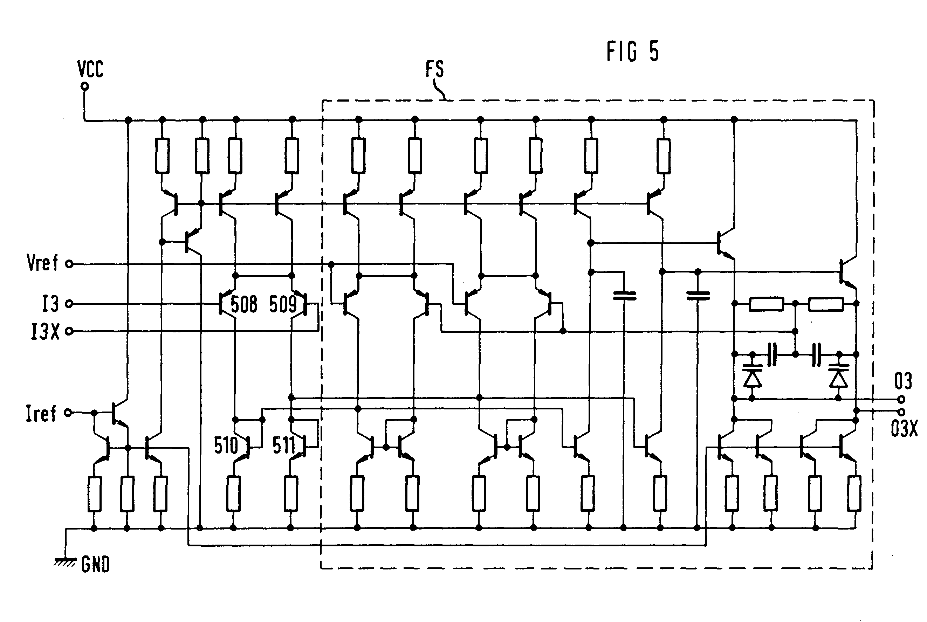

FIG 5 zeigt eine Filterschaltung 3, deren differentielle Eingangsklemmen I3 und I3X mit den Ausgangsklemmen 02 und O2X der Ausgangsstufe 2 verbunden sind. Über einen Eingangsdifferenzverstärker aus den Transistoren 508 bis 511 wird eine nicht näher beschriebene filternde Schaltung FS gespeist, die ausgangsseitig die Klemmen 03 und O3X hat, die mit dem nachfolgenden Schaltungselement 4 bzw. mit den Eingängen IN und INX der ersten Teilschaltung 5 des Regelkreises verbunden sind.

Kennzeichnend für die dargestellte Erfindung ist, daß von der Differenzverstärkerschaltung 1 bis zum Schaltungselement 4, das der Filterschaltung 3 nachgeschaltet ist, eine symmetrische DC-Kopplung möglich ist, so daß der Auswand für eine periphere Schaltungsanordnung sehr stark im Vergleich zu einer alternativen AC-Kopplung verringert wird. Ein DC-Offsetsignal wird am Ausgang der Filterschaltung 3 bzw. eines in der Filterschaltung enthaltenen Verstärkers gemessen und gespeichert. Dieses gespeicherte Signal wird mit einer Referenzspannung Uref verglichen und ein Offset-Kompensationssignal erzeugt, das in die Ausgangsstufe 2 der Differenzverstärkerschaltung 1 eingespeist wird und das der Offset-Spannung der Filterschaltung 3 derart entgegenwirkt, daß die Offsetspannung null oder minimal wird . Bei differentieller Ausführung des Nutzsignalpfades ist nur ein Kondensator C als externes Element für den symmetrischen Nutzsignalpfad erforderlich, das die Information zur Offsetkompensation speichert.

## Patentansprüche

1. Schaltungsanordnung, insbesondere für digitale Modulationseinrichtungen, mit einer Differenzverstärkerschaltung, die über eine Ausgangsstufe mit einer Filterschaltung verbunden ist,
**gekennzeichnet** durch
einen Regelkreis (2, 3, 5, 6, 7), bei dem eine Offsetspannung am Ausgang der Filterschaltung (3) eine Regelschaltung (5, 6, 7) steuert, welche ein Offset-Kompensationssignal (I, IX) in die Ausgangsstufe (2) einspeist.

2. Schaltungsanordnung nach Anspruch 1,
**dadurch gekennzeichnet**, daß
die Offsetspannung und das Offset-Kompensationssignal als differentielle Größen vorgesehen sind.

3. Schaltungsanordnung nach Anspruch 1 oder 2,
**dadurch gekennzeichnet**, daß
die Offsetspannung die Eingänge (IN, INX) einer ersten Teilschaltung (5) steuert, deren Ausgang mit einer Abtast- und Halteschaltung (6) verbunden ist, die wiederum eine zweite Teilschaltung (7) zur Erzeugung des Offset-Kompensationssignals steuert.

4. Schaltungsanordnung nach Anspruch 4,
**dadurch gekennzeichnet**, daß
die erste Teilschaltung (5) einen Verstärker mit zwei Eingängen (201 bis 205) enthält, denen die Offsetspannung differentiell zugeführt wird.

5. Schaltungsanordnung nach Anspruch 4 oder 5,
**dadurch gekennzeichnet**, daß
die zweite Teilschaltung (7) einen Komparator (209 bis 213, 219, 220) enthält, der ein Ausgangssignal der Abtast- und Halteschaltung (6) mit einem Referenzsignal (Uref) vergleicht und ausgangsseitig differentielle Kompensationsströme (I, IX) als Offset-Kompensationssignal erzeugt.

6. Schaltungsanordnung nach einem der Ansprüche 4 bis 5,
**dadurch gekennzeichnet**, daß
die Abtast- und Halteschaltung (6) eine Kapazität (C) enthält, die mit dem einen Eingang der zweiten Teilschaltung (7) und über einen Schalter (S) mit dem Ausgang der ersten Teilschaltung (5) verbunden ist.

7. Schaltungsanordnung nach einem der vorhergehenden Ansprüche,
**dadurch gekennzeichnet**, daß
das Offset-Kompensationssignal über eine Stromspiegelanordnung in die Ausgangsstufe (2) eingespeist wird.

8. Schaltungsanordnung nach einem der vorhergehenden Ansprüche,
**dadurch gekennzeichnet**, daß das
Nutzsignal der Ausgangsstufe (2) und das in die Ausgangsstufe eingespeiste Offset-Kompensationssignal parallel auf ein Lastelement (R, RX) arbeiten.

9. Schaltungsanordnung nach einem der vorhergehenden Ansprüche,
**dadurch gekennzeichnet**, daß die
Offsetspannung am Ausgang der Filterschaltung (3) erfaßt wird.

10. Schaltungsanordnung nach einem der vorhergehenden Ansprüche 1 bis 9,
**dadurch gekennzeichnet**, daß die
Differenzverstärkerschaltung (1) eine Mischerschaltung ist und daß die Filterschaltung (3) ein Basisbandfilter ist, das ausgangsseitig mit einem A/D-Wandler verbunden ist.

11. Schaltungsanordnung nach einem der vorhergehenden Ansprüche 1 bis 10,
**dadurch gekennzeichnet**, daß
der Regelkreis bei einem Burstbetrieb zur Erzeugung des Offset-Kompensationssignals vor einem Burstsignal geschlossen wird.

12. Schaltungsanordnung nach einem der Ansprüche 1 bis 11,
**dadurch gekennzeichnet**, daß
die Schaltungsanordnung vom Ausgang der Differenzverstärkerschaltung (1) bis zu einer der Filterschaltung (3) nachgeschalteten Anordnung DC gekoppelt ist.

## Claims

1. Circuit arrangement, in particular for digital modulation devices, having a differential amplifier circuit connected to a filter circuit via an output stage,
characterized by
a control loop (2, 3, 5, 6, 7), in which an offset voltage at the output of the filter circuit (3) controls a control circuit (5, 6, 7), which feeds an offset compensation signal (I, IX) into the output stage (2).

2. Circuit arrangement according to Claim 1,
characterized in that
the offset voltage and the offset compensation signal are provided as differential quantities.

3. Circuit arrangement according to Claim 1 or 2,
characterized in that
the offset voltage controls the inputs (IN, INX) of a first sub-circuit (5), whose output is connected to a sample-and-hold circuit (6), which in turn controls a second sub-circuit (7) for generating the offset compensation signal.

4. Circuit arrangement according to Claim 4,
characterized in that
the first sub-circuit (5) contains an amplifier having two inputs (201 to 205), to which the offset voltage is fed differentially.

5. Circuit arrangement according to Claim 4 or 5,
characterized in that
the second sub-circuit (7) contains a comparator (209 to 213, 219, 220), which compares an output signal of the sample-and-hold circuit (6) with a reference signal (Uref), and, on the output side, generates differential compensation currents (I, IX) as the offset compensation signal.

6. Circuit arrangement according to one of Claims 4 to 5,
characterized in that
the sample-and-hold circuit (6) contains a capacitance (C) connected to one input of the second sub-circuit (7) and, via a switch (S), to the output of the first sub-circuit (5).

7. Circuit arrangement according to one of the preceding claims,
characterized in that
the offset compensation signal is fed into the output stage (2) via a current mirror arrangement.

8. Circuit arrangement according to one of the preceding claims,
characterized in that
the useful signal of the output stage (2) and the offset compensation signal fed into the output stage operate in parallel on a load element (R, RX).

9. Circuit arrangement according to one of the preceding claims,
characterized in that the offset voltage is detected at the output of the filter circuit (3).

10. Circuit arrangement according to one of the preceding Claims 1 to 9,
characterized in that the differential amplifier circuit (1) is a mixer circuit, and in that the filter circuit (3) is a baseband filter connected to an A/D converter on the output side.

11. Circuit arrangement according to one of the preceding Claims 1 to 10,
characterized in that
the control loop is closed in a burst mode for generating the offset compensation signal before a burst signal.

12. Circuit arrangement according to one of Claims 1 to 11,
characterized in that
the circuit arrangement is DC-coupled from the output of the differential amplifier circuit (1) up to an arrangement connected downstream of the filter circuit (3).

## Revendications

1. Circuit destiné, en particulier, à des dispositifs numériques de modulation, avec un amplificateur différentiel relié, par l'intermédiaire d'un étage de sortie, à un filtre
**caractérisé par**
une boucle de régulation (2, 3, 5, 6, 7) dans laquelle une tension offset existant à la sortie du filtre (3) commande un circuit de régulation (5, 6, 7), qui injecte un signal de compensation de l'offset (I, IX) dans l'étage de sortie (2).

2. Circuit selon la revendication 1
**caractérisé par le fait**
que la tension offset et le signal de compensation de l'offset sont prévus comme grandeurs différentielles.

3. Circuit selon la revendication 1 ou 2
**caractérisé par le fait**
que la tension offset contrôle les entrées (IN, INX) d'un premier circuit partiel (5) dont la sortie est reliée à un circuit de balayage et de maintien (6), qui, de son côté, commande un deuxième circuit partiel (7) pour la génération du signal de compensation de l'offset.

4. Circuit selon la revendication 4
**caractérisé par le fait**
que le premier circuit partiel (5) comporte un amplificateur à deux entrées (201 à 205) auxquelles la tension offset est amenée d'une façon différentielle.

5. Circuit selon la revendication 4 ou 5
**caractérisé par le fait**
que le deuxième circuit partiel (7) comporte un comparateur (209 à 213, 219, 220), qui compare un signal de sortie du circuit de balayage et de maintien (6) à un signal de référence (U_{ref}) et génère, côté sortie, des courants de compensation différentiels (I, IX) comme signal de compensation de l'offset.

6. Circuit selon l'une des revendications 4 à 5
**caractérisé par le fait**
que le circuit de balayage et de maintien (6) comporte une capacité (C) qui est reliée à l'une des entrées du deuxième circuit partiel (7) et, à travers un commutateur (S), à une sortie du premier circuit partiel (5).

7. Circuit selon l'une des revendications précédentes
**caractérisé par le fait**
que le signal de compensation de l'offset est injecté, à travers un dispositif miroir de courant, dans l'étage de sortie (2).

8. Circuit selon l'une des revendications précédentes
**caractérisé par le fait**
que le signal utile de l'étage de sortie (2) et le signal de compensation de l'offset injecté dans l'étage de sortie travaillent en parallèle sur un élément de charge (R, RX).

9. Circuit selon l'une des revendications précédentes
**caractérisé par le fait**
que la tension offset est détectée à la sortie du filtre (3).

10. Circuit selon l'une des revendications précédentes 1 à 9
**caractérisé par le fait**
que le circuit amplificateur différentiel (1) est un circuit mélangeur et que le filtre (3) est un filtre de bande de base relié, côté sortie, à un convertisseur analogique/numérique.

11. Circuit selon l'une des revendications précédentes 1 à 10
**caractérisé par le fait**
que la boucle de régulation, dans le cas d'une exploitation en transmission par rafales, est fermée avant une rafale du signal pour générer le signal de compensation de l'offset.

12. Circuit selon l'une des revendications précédentes 1 à 11
**caractérisé par le fait**
que le circuit est couplé en courant continu depuis la sortie du circuit amplificateur différentiel (1) jusqu'à un dispositif placé en aval du filtre (3).
